# EUROPÄISCHE PATENTSCHRIFT

(11) **EP 3 240 024 B1**
(45) Veröffentlichungstag und Bekanntmachung des Hinweises auf die Patenterteilung: **28.11.2018**
(21) Anmeldenummer: 17167991.3
(22) Anmeldetag: 25.04.2017
(51) Int. Cl.: H01L 23/40, G01R 31/26

(54) **VERFAHREN ZUR ÜBERPRÜFUNG EINER MECHANISCHEN VERBINDUNG EINES KÜHLKÖRPERNIEDERHALTERS EINER KÜHLKÖRPERANORDNUNG, DIE EINEN KÜHLKÖRPER UND ZUMINDEST EINE ZU KÜHLENDE BAUTEILKOMPONENTE AUSWEIST, MIT EINER LEITERPLATTE**
METHOD FOR TESTING A MECHANICAL CONNECTION OF A HEATSINK RETENTION PART OF A HEAT SINK ASSEMBLY, COMPRISING A HEATSINK AND AT LEAST ONE COMPONENT WHICH NEED TO BE COOLED, WITH A PRINTED CIRCUIT BOARD
PROCÉDÉ DE CONTRÔLE D'UNE LIAISON MÉCANIQUE D'UN DISPOSITIF DE RETENUE DE CORPS DE REFROIDISSEMENT D'UN DISPOSITIF DE CORPS DE REFROIDISSEMENT PRÉSENTANT UN CORPS DE REFROIDISSEMENT ET AU MOINS UN COMPOSANT À REFROIDIR, AU MOYEN D'UN CIRCUIT IMPRIMÉ

(30) Priorität: 26.04.2016 DE 102016107731
(43) Veröffentlichungstag der Anmeldung: 01.11.2017
(73) Patentinhaber: Pilz GmbH & Co. KG, 73760 Ostfildern (DE)
(72) Erfinder: Cech, Markus, 73760 Ostfildern (DE); Godau, Thorsten, 73760 Ostfildern (DE)
(74) Vertreter: Manske, Jörg

(56) Entgegenhaltungen:
- DE-A1-102005 039 706
- US-A1- 2007 211 445
- US-B1- 6 683 449

## Beschreibung

Die vorliegende Erfindung betrifft ein Verfahren zur Überprüfung einer mechanischen Verbindung eines Kühlkörperniederhalters einer Kühlkörperanordnung, die einen Kühlkörper und zumindest eine zu kühlende Bauteilkomponente aufweist, mit einer Leiterplatte.

Heutzutage kommen hochintegrierte und immer leistungsfähigere elektronische Bauteilkomponenten, insbesondere in Form von Halbleiterchips, nicht nur auf dem Gebiet der Heim- und Unterhaltungselektronik, sondern auch in der industriellen Automatisierungstechnik zum Einsatz. Bei diesen Bauteilkomponenten können während des Betriebs relativ hohe Verlustleistungen auftreten, die als Wärmestrom in die Umgebung abgegeben werden. Aus diesem Grund müssen geeignete technische Maßnahmen ergriffen werden, um diese Bauteilkomponenten während ihres Betriebs in ausreichender Weise zu kühlen, so dass die Gefahr thermisch induzierter Beschädigungen verringert werden kann.

Auf dem Gebiet der Heim- und Unterhaltungselektronik werden die Bauteilkomponenten häufig ausschließlich passiv gekühlt, indem zum Beispiel eine Gehäusekomponente eines Gehäuses, innerhalb dessen die Bauteilkomponenten untergebracht sind, für eine Wärmeableitung verwendet wird. So ist es zum Beispiel bei Mobiltelefonen und Tablet-Computern bekannt, die zu kühlenden Bauteilkomponenten mit Hilfe wärmeleitender Stoffe, wie zum Beispiel flexiblen, auch als "Gapfiller" bezeichneten Stoffen auf Keramikbasis, direkt an metallische Gehäusekomponenten thermisch anzubinden, um dadurch eine gezielte Wärmeableitung zu ermöglichen.

Aus der Computertechnik sind Kühlkörperanordnungen bekannt, die einen Kühlkörper und einen aktiven Lüfter umfassen. Der Kühlkörper kann zum Beispiel mittels einer Wärmeleitpaste thermisch mit der zu kühlenden Bauteilkomponente verbunden sein. Mittels eines insbesondere rahmenartig ausgebildeten Halters aus Kunststoff kann der Kühlkörper zusammen mit dem Lüfter an einer Leiterplatte befestigt werden. Dieses erfolgt insbesondere durch Einclipsen des rahmenartigen Halters in die Leiterplatte.

Auch in der Automatisierungstechnik sind bereits Steuerungseinrichtungen bekannt, bei denen die Wärmeabfuhr zum Beispiel über einen Gehäuseboden und eine Montageschienenbefestigung erfolgt. Diese Art der Befestigung ist allerdings sehr aufwändig. Bei industriellen Bauteilkomponenten kommen daher sehr häufig Kühlkörper zum Einsatz, die von außen auf die zu kühlenden Bauteilkomponenten aufgesetzt werden. Diese Kühlkörper werden zumeist mit der Bauteilkomponente verklebt oder auch verclipst. Dabei ist es wünschenswert, eine schock- und vibrationsfeste Kühlkörperbefestigung an der Leiterplatte zu erhalten. Um zu prüfen, ob die mechanische Verbindung des Kühlkörpers mit der Leiterplatte auch realen Betriebsbedingungen standhält, werden entsprechende Tests durchgeführt, bei denen die Kühlkörperanordnung mechanischen Impulsen, Schwingungen oder dergleichen ausgesetzt wird. Dabei hat es sich gezeigt, dass die Art der Befestigung des Kühlkörpers ganz entscheidend ist, ob die Kühlkörperanordnung den im realen Betrieb auf sie einwirkenden mechanischen Beanspruchungen standhält oder nicht.

Um einen besonders sicheren Halt des Kühlkörpers an der Leiterplatte zu erreichen, ist es aus dem Stand der Technik bereits bekannt, den Kühlkörper nach dem Aufsetzen auf die zu kühlende Bauteilkomponente mit Hilfe spezieller Kühlkörperniederhalter an der Leiterplatte zu befestigen. Dadurch kann eine schock- und vibrationsfeste Befestigung des Kühlkörpers an der Leiterplatte erreicht werden.

In der US 5,932,925 wird ein bügelartiger Niederhalter für einen Kühlkörper beschrieben, der durch Verrasten und zusätzliches Verschrauben an einem Leiterplattenabschnitt, der einen Halbleiterchip trägt, befestigt werden kann. Der Leiterplattenabschnitt bildet dabei eine Schnittstelle dieser Anordnung zu einer gedruckten Leiterplatte.

Aus der DE 10 2011 075 661 A1 ist eine Kühlkörperanordnung bekannt, bei der ein Kühlkörper mittels einer Klammer an einer Leiterplatte befestigt ist. Die Klammer weist zwei hakenartige Enden auf, die in damit korrespondierende Aussparungen in der Leiterplatte eingreifen können.

Die KR 1054870 B1 offenbart eine Leiterplatte mit einer darauf angeordneten elektronischen Bauteilkomponente. Ein Kühlkörper für diese Bauteilkomponente ist mittels einer Federklammer, die aus Metall hergestellt sein kann und vier Beine mit daran ausgebildeten Eingriffsabschnitten aufweist, an der Leiterplatte befestigt. Die Eingriffsabschnitte greifen bei der Montage in die Eingriffsöffnungen ein, die in der Leiterplatte ausgebildet sind, und ermöglichen dadurch eine Befestigung des Kühlkörpers an der Leiterplatte.

Für die Befestigung des Kühlkörpers an der Leiterplatte, insbesondere unter Verwendung eines Kühlkörperniederhalters, sind zusätzliche Fertigungsschritte erforderlich. Das automatisierte Prüfen der korrekten Fertigung kommt bei mechanischen Komponenten insbesondere unter Aufwand-Nutzen-Aspekten oftmals an seine Grenzen.

Aus der US 6,683,449 B1 ist ein Verfahren zur Überprüfung einer mechanischen Verbindung eines Kühlkörperniederhalters einer Kühlkörperanordnung, die einen Kühlkörper und zumindest ein zu kühlendes Bauteil aufweist, mit einer Leiterplatte bekannt, welches die Schritte umfasst
a) Bereitstellen eines ersten elektrischen Kontakts und eines zweiten elektrischen Kontakts in oder an der Leiterplatte, mit denen der Kühlkörperniederhalter verbindbar ist,
b) Bereitstellen einer Auswerteeinheit mit einem Analog- oder Digitaleingang, der an eine Spannungsversorgungseinrichtung und an den ersten elektrischen Kontakt angeschlossen wird,
c) Erzeugen einer elektrischen Spannung am Analog- oder Digitaleingang der Auswerteeinheit mittels der Spannungsversorgungseinrichtung,
d) Überprüfen, ob die elektrische Spannung am Analog- oder Digitaleingang der Auswerteeinheit eine High-Pegel-Spannung oder eine Low-Pegel-Spannung ist.

Dieses Verfahren ermöglicht auf einfache Weise eine Überprüfung der mechanischen Verbindung des Kühlkörperniederhalters mit der elektrischen Leiterplatte. Wenn die am Analog- oder Digitaleingang gemessene elektrische Spannung eine High-Pegel-Spannung ist, ist die Montage des Kühlkörperniederhalters nicht in korrekter Weise erfolgt, so dass geeignete Nacharbeitungsschritte erforderlich sind. Wenn demgegenüber die elektrische Spannung am Analog- oder Digitaleingang eine Low-Pegel-Spannung ist, wurde der Kühlkörperniederhalter ordnungsgemäß mit der Leiterplatte mechanisch verbunden. Bei der Verwendung eines Analogeingangs ist das Eingangssignal ein analoger Strom- oder Spannungswert. Bei der Verwendung eines Digitaleingangs ist das Eingangssignal ein Digitalpegel.

Es hat sich gezeigt, dass unter Umständen vorhandene Lötbrücken gegenüber einem Massepotential, die am Analog- oder Digitaleingang der Auswerteeinheit vorhanden sein können, an diesem Analog- oder Digitaleingang zu einem Low-Pegel-Spannungssignal führen können, welches nach dem zuvor Gesagten an sich auf einen korrekt montierten Kühlkörperniederhalter hindeutet, obwohl dieser möglicherweise nicht richtig montiert wurde.

Die vorliegende Erfindung macht es sich zur Aufgabe, ein Verfahren zur Überprüfung einer mechanischen Verbindung eines Kühlkörperniederhalters einer Kühlkörperanordnung, die einen Kühlkörper und zumindest eine zu kühlende Bauteilkomponente aufweist, mit einer Leiterplatte zur Verfügung zu stellen, welches die Überprüfung der Verbindung auf sehr einfache Art und Weise ermöglicht.

Die Lösung dieser Aufgabe liefert ein Verfahren zur Überprüfung einer mechanischen Verbindung eines Kühlkörperniederhalters einer Kühlkörperanordnung mit einer Leiterplatte mit den Merkmalen des Anspruchs 1. Die Unteransprüche betreffen vorteilhafte Weiterbildungen der Erfindung.

Gemäß Anspruch 1 umfasst ein erfindungsgemäßes Verfahren zur Überprüfung einer mechanischen Verbindung eines Kühlkörperniederhalters einer Kühlkörperanordnung, die einen

Kühlkörper und zumindest ein zu kühlendes Bauteil aufweist, mit einer Leiterplatte, die Schritte
a) Bereitstellen eines ersten elektrischen Kontakts und eines zweiten elektrischen Kontakts in oder an der Leiterplatte, mit denen der Kühlkörperniederhalter verbindbar ist,
b) Bereitstellen einer Auswerteeinheit mit einem Spannungsausgang, der an den ersten elektrischen Kontakt angeschlossen wird, und mit einem Analog- oder Digitaleingang, der an den zweiten elektrischen Kontakt angeschlossen wird,
c) Erzeugen eines ersten gepulsten Ausgangsspannungssignals am Spannungsausgang, das zumindest einen Flankenwechsel aufweist,
d) Überprüfen, ob die elektrische Spannung am Analog- oder Digitaleingang den mindestens einen Flankenwechsel des ersten gepulsten Ausgangsspannungssignals aufweist,
e) Erzeugen eines zweiten gepulsten Ausgangsspannungssignals am Spannungsausgang, das zumindest einen Flankenwechsel aufweist, der vom Flankenwechsel des ersten gepulsten Ausgangsspannungssignals verschieden ist,
f) Überprüfen, ob die elektrische Spannung am Analog- oder Digitaleingang den mindestens einen Flankenwechsel des zweiten gepulsten Ausgangsspannungssignals aufweist.

Das erfindungsgemäße Verfahren ermöglicht auf einfache Weise eine Überprüfung der ordnungsgemäßen Befestigung des Kühlkörperniederhalters an der Leiterplatte. Nur wenn der Flankenwechsel des ersten gepulsten Spannungssignals über den zweiten Kontakt und den Analog- oder Digitaleingang der Auswerteeinheit korrekt erfasst und dadurch gewissermaßen "zurückgelesen" wird, ist der Kühlkörperniederhalter ordnungsgemäß an der Leiterplatte befestigt. Anderenfalls ist die mechanische Verbindung fehlerhaft, so dass entsprechende Nacharbeiten erforderlich sind. Bei der Verwendung eines Analogeingangs ist das Eingangssignal ein analoger Strom- oder Spannungswert. Bei der Verwendung eines Digitaleingangs ist das Eingangssignal ein Digitalpegel.

Um die Qualität der Messergebnisse weiter zu erhöhen, umfasst das erfindungsgemäße Verfahren die oben bereits genannten Schritte
e) Erzeugen eines zweiten gepulsten Ausgangsspannungssignals am Spannungsausgang, das zumindest einen Flankenwechsel aufweist, der vom Flankenwechsel des ersten gepulsten Ausgangsspannungssignals verschieden ist,
f) Überprüfen, ob die elektrische Spannung am Analog- oder Digitaleingang den mindestens einen Flankenwechsel des zweiten gepulsten Ausgangsspannungssignals aufweist.

Nur wenn sowohl der Flankenwechsel des ersten gepulsten Spannungssignals, als auch der Flankenwechsel des zweiten gepulsten Spannungssignals über den zweiten Kontakt und den Analog- oder Digitaleingang der Auswerteeinheit korrekt erfasst und dadurch "zurückgelesen" werden, ist der Kühlkörperniederhalter ordnungsgemäß an der Leiterplatte befestigt.

Vorzugsweise können der Analog- oder Digitaleingang und der Spannungsausgang der Auswerteeinheit konfigurierbar ausgeführt werden. Dadurch wird die Möglichkeit geschaffen, die Eigenschaften des Analog- oder Digitaleingangs und des Spannungsausgangs zu verändern. Beispielsweise ist es denkbar, den vormals als Analog- oder Digitaleingang betriebenen elektrischen Anschluss der Auswerteeinheit so zu konfigurieren, dass er als Spannungsausgang betrieben werden kann und umgekehrt den vormals als Spannungsausgang betriebenen Anschluss der Auswerteeinheit so zu konfigurieren, dass er als Analog- oder Digitaleingang betrieben werden kann. Die Funktionen der beiden Anschlüsse können somit vertauscht werden, um zum Beispiel in dieser "umgekehrten" Konfiguration zusätzliche Kontrollmessungen durchführen zu können, um die Messungen in der anderen Anschlusskonfiguration zu validieren.

Vorzugsweise können die elektrischen Kontakte in Aufnahmeöffnungen der Leiterplatte bereitgestellt werden, in die der Kühlkörperniederhalter bei der Montage einsteckbar ist. Somit sind die elektrischen Kontakte genau dort vorgesehen, wo der Kühlkörperniederhalter in die Leiterplatte eingesteckt wird.

Grundsätzlich kann der Kühlkörperniederhalter auch mit der Leiterplatte verlötet sein. In einer vorteilhaften Ausführungsform kann daher vorgesehen sein, dass die elektrischen Kontakte durch Lötabschnitte bereitgestellt werden, an denen der Kühlkörperniederhalter bei der Montage mit der Leiterplatte verlötet wird. Die Lötabschnitte können für eine Oberflächenmontage des Kühlkörperniederhalters an einer Oberfläche der Leiterplatte vorgesehen sein. Alternativ können die Lötabschnitte auch im Bereich der Aufnahmeöffnungen ausgebildet sein. Bei dieser Variante wird der Kühlkörperniederhalter bei der Montage in die Aufnahmeöffnungen eingesetzt und zusätzlich mit der Leiterplatte verlötet.

Das hier beschriebene Verfahren ermöglicht auf sehr einfache Art und Weise die Überprüfung der ordnungsgemäßen mechanischen Verbindung des Kühlkörperniederhalters mit der Leiterplatte und können zum Beispiel im Rahmen eines Gerätefunktionstests am Ende der Fertigung ausgeführt werden.

Weitere Merkmale und Vorteile der vorliegenden Erfindung werden deutlich anhand der nachfolgenden Beschreibung bevorzugter Ausführungsbeispiele unter Bezugnahme auf die beiliegenden Abbildungen. Darin zeigen:
- Fig. 1: eine Seitenansicht einer Kühlkörperanordnung gemäß einer ersten Ausführungsvariante,
- Fig. 2: eine Draufsicht auf die Kühlkörperanordnung gemäß Fig. 1,
- Fig. 3: eine Seitenansicht einer Kühlkörperanordnung gemäß einer zweiten Ausführungsvariante,
- Fig. 4: eine in Bezug auf Fig. 3 um 90° gedrehte Seitenansicht der Kühlkörperanordnung,
- Fig. 5: eine Seitenansicht einer Kühlkörperanordnung gemäß einer dritten Ausführungsvariante,
- Fig. 6: eine in Bezug auf Fig. 5 um 90° gedrehte Seitenansicht der Kühlkörperanordnung,
- Fig. 7: eine Seitenansicht einer Kühlkörperanordnung gemäß einer vierten Ausführungsvariante,
- Fig. 8: eine in Bezug auf Fig. 7 um 90° gedrehte Seitenansicht der Kühlkörperanordnung,
- Fig. 9: eine Seitenansicht einer Kühlkörperanordnung gemäß einer fünften Ausführungsvariante,
- Fig. 10: eine in Bezug auf Fig. 9 um 90° gedrehte Seitenansicht der Kühlkörperanordnung,
- Fig. 11: eine Seitenansicht einer Kühlkörperanordnung gemäß einer sechsten Ausführungsvariante,
- Fig. 12: eine in Bezug auf Fig. 11 um 90° gedrehte Seitenansicht der Kühlkörperanordnung,
- Fig. 13: eine perspektivische Ansicht eines Einsteckverbindungsmittels, das bei der Kühlkörperanordnung gemäß Fig. 11 und 12 verwendet wird,
- Fig. 14: ein erstes Ausführungsbeispiel einer Schaltungsanordnung zur Überprüfung einer mechanischen Verbindung eines Kühlkörperniederhalters einer Kühlkörperanordnung mit einer Leiterplatte,
- Fig. 15: ein zweites Ausführungsbeispiel einer Schaltungsanordnung zur Überprüfung einer mechanischen Verbindung eines Kühlkörperniederhalters einer Kühlkörperanordnung mit einer Leiterplatte.

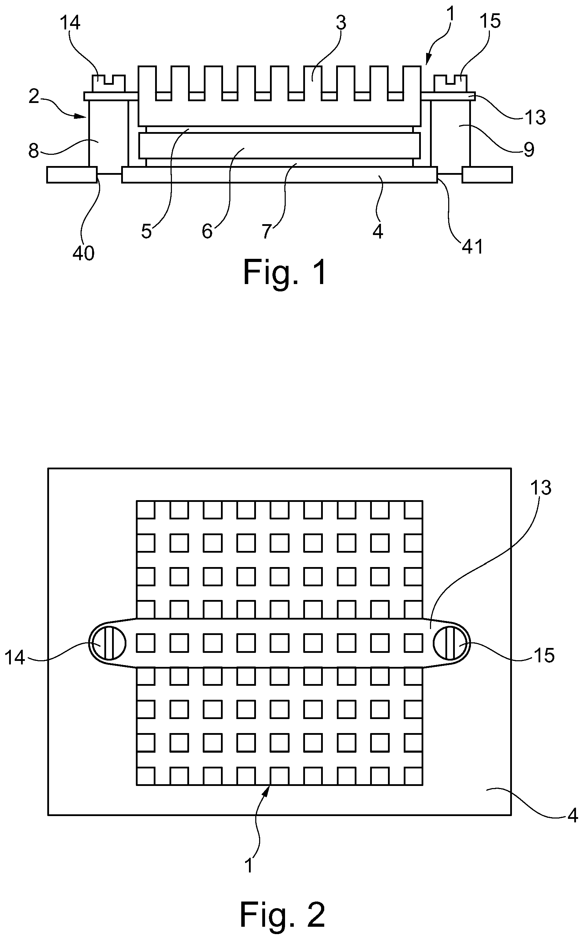

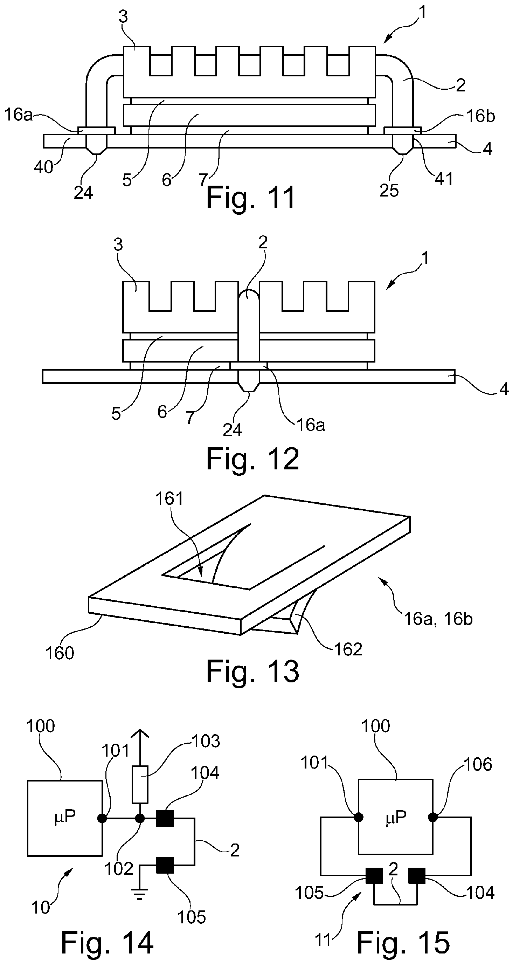

Unter Bezugnahme auf Fig. 1 bis 13 sollen einleitend exemplarisch sechs verschiedene Ausführungsvarianten von Kühlkörperanordnungen 1 näher erläutert werden, die jeweils einen Kühlkörperniederhalter 2 für einen Kühlkörper 3 aufweisen. Der Kühlkörperniederhalter 2 ist in allen Ausführungsvarianten mit einer Leiterplatte 4 verbunden. Die ordnungsgemäße mechanische Verbindung des Kühlkörperniederhalters 2 mit der Leiterplatte 4 kann zum Beispiel mit Hilfe der beiden Schaltungsanordnungen 10, 11, die in Fig. 14 und 15 dargestellt sind, überprüft werden.

In jedem der Ausführungsbeispiele der Kühlkörperanordnungen 1 ist der Kühlkörper 3 unter Zwischenlage einer wärmeleitenden Schicht 5 auf einer zu kühlenden elektronischen Bauteilkomponente 6, die vorliegend ein Halbleiterchip ist, angeordnet. Die wärmeleitende Schicht 5 kann zum Beispiel durch einen Gap-Filler, eine Wärmeleitpaste oder einen Wärmeleitkleber gebildet sein. Die zu kühlende Bauteilkomponente 6 ist ihrerseits über eine Lötfläche 7 mit der Leiterplatte 4 verbunden.

Unter Bezugnahme auf Fig. 1 und 2 weist die Kühlkörperanordnung 1 gemäß einer ersten Ausführungsvariante einen vorliegend mehrteilig ausgeführten Kühlkörperniederhalter 2 auf, der zwei sich senkrecht zur Ebene der Leiterplatte 4 erstreckende Haltemittel 8, 9 aus einem metallischen Werkstoff umfasst, die vorzugsweise als Stehbolzen ausgeführt sind und zum Beispiel durch Oberflächenmontage (englisch: "Surface-Mounting-Technology", kurz: SMT) mit der Leiterplatte 4 verbunden werden können. Die Leiterplatte 4 weist zwei insbesondere als Bohrungen ausgeführte Aufnahmeöffnungen 40, 41 auf. Die beiden Haltemittel 8, 9 können zum Beispiel abschnittsweise in die entsprechenden Montageöffnungen 40, 41 der Leiterplatte 4 eingepresst sein. Alternativ oder zusätzlich können die beiden Haltemittel 8, 9 auch mit der Leiterplatte 4 verlötet sein.

Der Kühlkörperniederhalter 2 umfasst ferner ein flaches Niederhalteelement 13, das ebenfalls aus einem metallischen Werkstoff hergestellt ist und sich in seiner Montagesolllage zwischen den beiden Haltemitteln 8, 9 erstreckt. Die Höhe der beiden Haltemittel 8, 9 ist so gewählt, dass das Niederhalteelement 13 - wie insbesondere in Fig. 2 zu erkennen - in seiner Montagesolllage abschnittsweise auf einem Teilbereich der Oberseite des Kühlkörpers 3 aufliegt. Mittels zweier Montageschrauben 14, 15 ist das Niederhalteelement 13 an den beiden Haltemitteln 8, 9 befestigt. Für eine einfache und kostengünstige Herstellung kann das Niederhalteelement 13 vorzugsweise als Stanzteil ausgebildet sein, welches an die Oberflächenstruktur des Kühlkörpers 3 angepasst ist. Der Kühlkörperniederhalter 2 ermöglicht eine schock- und vibrationsfeste Befestigung des Kühlkörpers 3 an der Leiterplatte 4. Der vorstehend beschriebene Aufbau weist allerdings den Nachteil auf, dass die Montage des Kühlkörperniederhalters 2 nicht zuletzt aufgrund der mehrteiligen Ausgestaltung relativ aufwändig ist und insbesondere eine höhenpräzise Ausgestaltung der beiden Haltemittel 8, 9 erfordert.

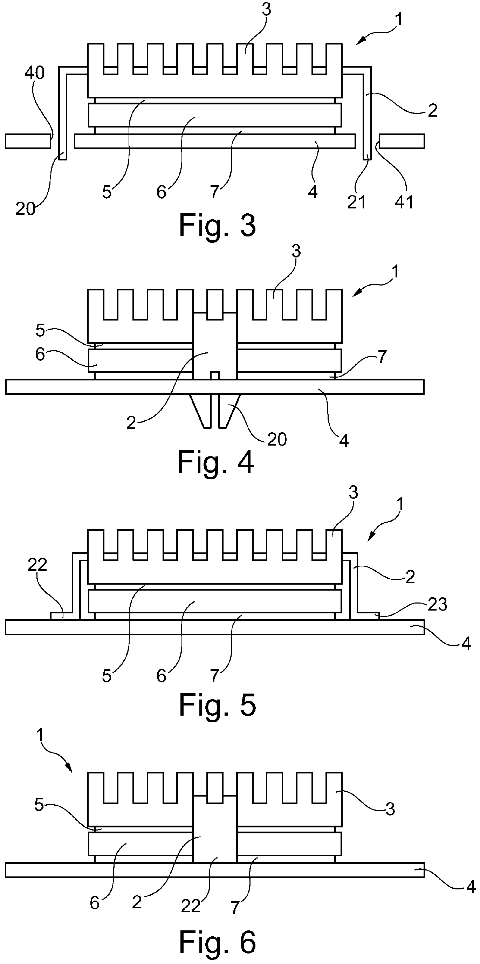

Unter Bezugnahme auf Fig. 3 und 4 ist dort eine Kühlkörperanordnung 1 gezeigt, die einen einteilig ausgeführten Kühlkörperniederhalter 2 umfasst, der insbesondere als Stanz-Biegeteil ausgeführt sein kann, und keine zusätzlichen separaten Haltemittel 8, 9 und Montageschrauben 14, 15 für die Befestigung an der Leiterplatte 4 erfordert. Der Kühlkörperniederhalter 2 ist ebenfalls aus einem metallischen und somit elektrisch leitenden Werkstoff hergestellt und im Wesentlichen U-förmig gebogen ausgeführt. An seinen Enden weist der Kühlkörperniederhalter 2 jeweils ein Rastverbindungsmittel 20, 21 auf, mittels dessen der Kühlkörperniederhalter 2 rastend in den damit korrespondierenden Aufnahmeöffnungen 40, 41 der Leiterplatte 4 festgelegt werden kann. Diese Rastverbindungsmittel 20, 21 können zusätzlich mit der Leiterplatte 4, insbesondere durch eine Selektivverlötung, verlötet werden, um dadurch einen weiter verbesserten Halt des Kühlkörperniederhalters 2 an der Leiterplatte 4 zu erhalten.

In einer dritten Ausführungsvariante, die in Fig. 5 und 6 dargestellt ist, besteht auch die Möglichkeit, den Kühlkörperniederhalter 2 in SMT-Technik auszuführen, so dass er durch Oberflächenmontage an der Leiterplatte 4 befestigt werden kann. Zu diesem Zweck weist der Kühlkörperniederhalter 2 an einem unteren Ende zwei einander gegenüberliegend angeordnete Aufstandsflächen 22, 23 auf, die bei der Montage zumindest abschnittsweise mit der Leiterplatte 4 verlötet werden. Somit sind keine Aufnahmeöffnungen 40, 41 in der Leiterplatte 4 für die Befestigung des Kühlkörperniederhalters 2 erforderlich. Der Kühlkörperniederhalter 2 ist wiederum als Stanz-Biegeteil aus einem metallischen Werkstoff und somit elektrisch leitend ausgeführt.

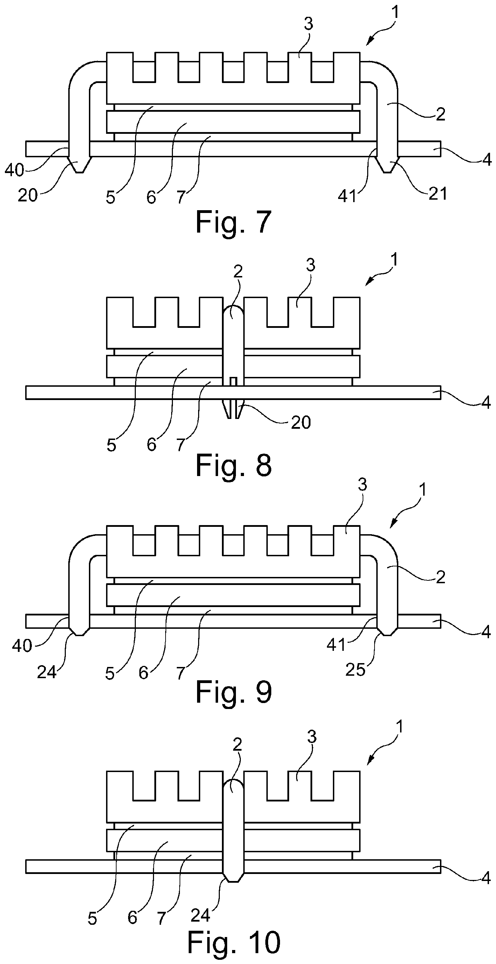

Gemäß einem weiteren Ausführungsbeispiel, welches in Fig. 7 und 8 gezeigt ist, kann der Kühlkörperniederhalter 2 auch aus einem Rundmaterial in Gestalt eines Drahtniederhalters aus einem metallischen Werkstoff ausgebildet sein, der im Wesentlichen U-förmig gebogen ausgeführt ist. An seinen Enden weist der Kühlkörperniederhalter 2 jeweils ein Rastverbindungsmittel 20, 21 auf. Mit Hilfe der Rastverbindungsmittel 20, 21 kann der Kühlkörperniederhalter 2 rastend in den damit korrespondierenden Aufnahmeöffnungen 40, 41 der Leiterplatte 4 festgelegt werden. Eine selektive Verlötung der Rastverbindungsmittel 20, 21 mit der Leiterplatte 4 ist optional ebenfalls möglich, um auf diese Weise einen weiter verbesserten mechanischen Halt des Kühlkörperniederhalters 2 zu erreichen.

Unter Bezugnahme auf Fig. 9 und 10 ist der Kühlkörperniederhalter 2 gemäß einer fünften, besonders einfach ausgeführten Ausführungsvariante ebenfalls aus einem metallischen Rundmaterial hergestellt und in Form eines Drahtniederhalters ausgebildet. Die freien Enden 24, 25 des Kühlkörperniederhalters 2 werden bei der Montage in die damit korrespondierenden Aufnahmeöffnungen 40, 41 der Leiterplatte 4 eingesetzt und mit der Leiterplatte 4 verlötet. Dadurch kann eine stoffschlüssige Verbindung des Kühlkörperniederhalters 2 mit der Leiterplatte 4 erhalten werden.

In einer sechsten Ausführungsvariante ist der Kühlkörperniederhalter 2 wiederum aus einem metallischen Rundmaterial hergestellt und in Form eines Drahtniederhalters ausgebildet. In dieser Ausführungsvariante kann auf eine Verlötung des Kühlkörperniederhalters 2 mit der Leiterplatte 4 verzichtet werden. Für die Befestigung des Kühlkörperniederhalters 2 an der Leiterplatte 4 werden zwei Einsteckverbindungsmittel 16a, 16b (Einsteck-Clips) verwendet, die jeweils in einem herkömmlichen Lötprozess oberhalb der Aufnahmeöffnungen 40, 41 stoffschlüssig mit der Leiterplatte 4 verbunden werden. Eines dieser beiden Einsteckverbindungsmittel 16a, 16b ist in Fig. 13 perspektivisch dargestellt. Die Einsteckverbindungsmittel 16a, 16b weisen eine Haltefläche 160 auf, die in der Montagesolllage eine Löt- und Kontaktfläche mit der Leiterplatte 4 bildet. Die Einsteckverbindungsmittel 16a, 16b weisen ferner eine Einstecköffnung 161 auf, in die bei der Montage jeweils ein freies Ende 24, 25 des Kühlkörperniederhalters 2 eingesteckt werden kann. Um einen sicheren Halt der freien Enden 24, 25 des Kühlkörperniederhalters 2 in den Aufnahmeöffnungen 40, 41 der Leiterplatte 4 zu bewirken, weisen die Einsteckverbindungsmittel 16a, 16b jeweils eine elastische Haltezunge 162 auf. Bei der Montage werden die freien Enden 24, 25 des Kühlkörperniederhalters 2 einfach in die Einstecköffnung 161 des ihnen zugeordneten Einsteckverbindungsmittels 16a, 16b eingedrückt und anschließend in die Aufnahmeöffnungen 40, 41 der Leiterplatte 4 eingesetzt. Die Haltezunge 161 eines jeden der beiden Einsteckverbindungsmittel 16a, 16b ist so ausgebildet, dass ein Herausrutschen des Kühlkörperniederhalters 2 aus den Aufnahmeöffnungen 40, 41 der Leiterplatte 4 und aus den Einstecköffnungen 161 der Einsteckverbindungsmittel 16a, 16b auch unter dem Einfluss von Temperaturschwankungen wirksam verhindert werden kann.

Alle hier beschriebenen Kühlkörperanordnungen 1 ermöglichen in vorteilhafter Weise auch die Verwendung einer kostengünstigen Klebefolie zur Ausbildung der wärmeleitenden Schicht 5, mittels derer der Kühlkörper 3 mit der zu kühlenden Bauteilkomponente 6 stoffschlüssig verbunden werden kann. Die in den vorstehend beschriebenen Ausführungsvarianten verwendeten Kühlkörperniederhalter 2 bieten grundsätzlich einen sicheren Halt der Kühlkörperanordnung 1 an der Leiterplatte 4, insbesondere auch bei Vibrationen und/oder mechanischen Stößen. Dieses setzt jedoch voraus, dass der Kühlkörperniederhalter 2 ordnungsgemäß an der Leiterplatte 4 montiert wurde, da er sich ansonsten unter dem Einfluss von Vibrationen, mechanischen Stößen oder dergleichen lösen könnte, so dass ein sicherer Halt an der Leiterplatte 4 nicht mehr gewährleistet wäre.

Um die mechanische Verbindung des Kühlkörperniederhalters 2 mit der Leiterplatte 4 nach der Montage auf einfache Weise überprüfen zu können, sollen nachfolgend unter Bezugnahme auf Fig. 14 und 15 zwei Schaltungsanordnungen 10, 11 näher erläutert werden, mittels derer eine derartige Überprüfung möglich ist.

Gemäß einem ersten Ausführungsbeispiel, das in Fig. 14 dargestellt ist, umfasst die Schaltungsanordnung 10 eine Auswerteeinheit 100, der einen elektrischen Analog- oder Digitaleingang 101 aufweist. Der Analog- oder Digitaleingang 101 der Auswerteeinheit 100 ist mittels eines Knotenpunkts 102 einerseits über einen Vorwiderstand 103 an eine hier nicht explizit dargestellte Spannungsversorgungseinrichtung anschließbar und andererseits an einen ersten elektrischen Kontakt 104, mit dem ein erstes Ende des Kühlkörperniederhalters 2 mechanisch verbindbar ist, angeschlossen. Die Schaltungsanordnung 10 weist ferner einen zweiten elektrischen Kontakt 105 auf, der auf einem Massepotential liegt.

Die Positionen, an denen die beiden elektrischen Kontakte 104, 105 vorgesehen sind, hängen insbesondere davon ab, wo und in welcher Weise der Kühlkörperniederhalter 2 der jeweiligen Kühlkörperanordnung 1 bei der Montage mit der Leiterplatte 4 verbunden wird. Bei dem in Fig. 1 und 2 beschriebenen Ausführungsbeispiel der Kühlkörperanordnung 1 können die elektrischen Kontakte 104, 105 vorzugsweise im Bereich der beiden Aufnahmeöffnungen 40, 41 der Leiterplatte 4 ausgebildet sein, in die die Haltemittel 8, 9 bei der Montage eingepresst beziehungsweise oberhalb derer die Haltemittel 8, 9 mit der Leiterplatte 4 verlötet werden. Bei einem nicht beziehungsweise nicht ordnungsgemäß montierten Kühlkörperniederhalter 2 wird am elektrischen Analog- oder Digitaleingang 101 der Auswerteeinheit 100 bei eingeschalteter Spannungsversorgungseinrichtung eine High-Pegel-Spannung erzeugt. Ist der Kühlkörperniederhalter 2 demgegenüber in korrekter Weise mechanisch mit der Leiterplatte 4 verbunden, liegt am Analog- oder Digitaleingang 101 der Auswerteeinheit 100 eine Low-Pegel-Spannung an. Durch eine Messung, ob am Analog- oder Digitaleingang 101 der Auswerteeinheit 100 eine High-Pegel-Spannung (d.h. eine höhere Spannung) oder eine Low-Pegel-Spannung (d.h. eine niedrigere Spannung) anliegt, kann folglich darauf geschlossen werden, ob der Kühlkörperniederhalter 2 bei der Montage ordnungsgemäß mit der Leiterplatte 4 verbunden wurde. Insbesondere kann dabei auch überprüft werden, ob die beiden Haltemittel 8, 9 für das flache Niederhalteelement 13 des Kühlkörperniederhalters 2 richtig in den Aufnahmeöffnungen 40, 41 der Leiterplatte 4 beziehungsweise an der Leiterplatte 4 montiert wurden.

In der zweiten (Fig. 3 und 4), vierten (Fig. 7 und 8), fünften (Fig. 9 und 10) sowie sechsten (Fig. 11 bis 23) Ausführungsvariante der Kühlkörperanordnung 1 ist es ebenfalls zweckmäßig, die Kontakte 104, 105 im Bereich der beiden Aufnahmeöffnungen 40, 41 der Leiterplatte 4 vorzusehen. Wenn der Kühlkörperniederhalter 2 ordnungsgemäß in den Aufnahmeöffnungen 40, 41 der Leiterplatte 4 festgelegt wurde, wird bei aktivierter Spannungsversorgungseinrichtung am Analog- oder Digitaleingang 101 der Auswerteeinheit 100 eine Low-Pegel-Spannung erzeugt. Wenn die Montage des Kühlkörperniederhalters 2 nicht ordnungsgemäß vorgenommen wurde, kann am Analog- oder Digitaleingang 101 der Auswerteeinheit 100 eine High-Pegel-Spannung erfasst werden.

Im dritten Ausführungsbeispiel (Fig. 5 und 6) werden die elektrischen Kontakte 104, 105 im Bereich der Lötstellen vorgesehen. Wenn die Lötstellen nicht fehlerhaft sind, wird am Analog- oder Digitaleingang 101 der Auswerteeinheit 100 bei eingeschalteter Spannungsversorgungseinrichtung eine Low-Pegel-Spannung erzeugt. Anderenfalls kann eine High-Pegel-Spannung gemessen werden, die insbesondere auf eine fehlerhafte Lötverbindung hindeutet.

Die in Fig. 14 gezeigte Schaltungsanordnung 100 ermöglicht in vorteilhafter Weise eine Überprüfung, ob der Kühlkörperniederhalter 2 bei der Montage ordnungsgemäß mit der Leiterplatte 4 verbunden wurde. Die Erfassung einer High-Pegel-Spannung am Analog- oder Digitaleingang 101 der Auswerteeinheit 100 lässt darauf schließen, dass der Kühlkörperniederhalter 2 keine zuverlässige mechanische Verbindung mit der Leiterplatte 4 aufweist.

Untersuchungen haben ergeben, dass unter Umständen vorhandene Lötbrücken gegen Masse am Analog- oder Digitaleingang 101 der Auswerteeinheit 100 an diesem Analog- oder Digitaleingang 101 zu einer Low-Pegel-Spannung führen, der an sich auf einen ordnungsgemäß montierten Kühlkörperniederhalter 2 hindeutet, obwohl dieser möglicherweise nicht richtig montiert wurde.

Um diesem Problem und den damit verbundenen Ungenauigkeiten bei der Überprüfung der mechanischen Verbindung des Kühlkörperniederhalters 2 mit der Leiterplatte 4 abzuhelfen, wird in einem zweiten Ausführungsbeispiel einer Schaltungsanordnung 11 vorgeschlagen, eine Auswerteeinheit 100 mit einem Analog- oder Digitaleingang 101 und einem Spannungsausgang 106 vorzusehen. Der Analog- oder Digitaleingang 101 und der Spannungsausgang 106 sind vorzugsweise konfigurierbar ausgeführt, so dass deren Eigenschaften von einem Benutzer geändert werden können. Wie in Fig. 15 zu erkennen, ist der Spannungsausgang 106 mit einem ersten elektrischen Kontakt 104 für den Kühlkörperniederhalter 2 verbunden. Der Analog- oder Digitaleingang 101 ist demgegenüber mit einem zweiten elektrischen Kontakt 105 für den Kühlkörperniederhalter 2 verbunden. Die beiden elektrischen Kontakte 104, 105 für den Kühlkörperniederhalter 2 können in der oben beschriebenen Weise ausgeführt sein.

Für eine Überprüfung der ordnungsgemäßen mechanischen Verbindung des Kühlkörperniederhalters 2 mit der Leiterplatte 4 wird über den Spannungsausgang 106 der Auswerteeinheit 100 am ersten elektrischen Kontakt 104 für den Kühlkörperniederhalter 2 ein gepulstes Spannungssignal erzeugt, das einen Flankenwechsel aufweist. Wenn dieser Flankenwechsel am zweiten elektrischen Kontakt 105, der mit dem Analog- oder Digitaleingang 101 verbunden ist, exakt "zurückgelesen" wird und somit am Analog- oder Digitaleingang 101 erfasst werden kann, kann davon ausgegangen werden, dass der Kühlkörperniederhalter 2 ordnungsgemäß montiert wurde und insbesondere keine Lötbrücken am Analog- oder Digitaleingang 101 existieren.

Um die Genauigkeit weiter zu erhöhen, kann zum Beispiel auch vorgesehen sein, dass die mechanische Verbindung des Kühlkörperniederhalters 2 mit der Leiterplatte 4 mittels eines ersten gepulsten Spannungssignals, das einen Flankenwechsel aufweist, und mittels (mindestens) eines zweiten gepulsten Spannungssignals, das einen Flankenwechsel aufweist, der vom Flankenwechsel des ersten gepulsten Spannungssignals verschieden ist, überprüft wird. Wenn die beiden Flankenwechsel am zweiten elektrischen Kontakt 105, der mit dem Analog- oder Digitaleingang 101 verbunden ist, exakt "zurückgelesen" und am Analog- oder Digitaleingang 105 erfasst werden, kann davon ausgegangen werden, dass der Kühlkörperniederhalter 2 in ordnungsgemäßer Weise montiert wurde.

## Patentansprüche

1. Verfahren zur Überprüfung einer mechanischen Verbindung eines Kühlkörperniederhalters (2) einer Kühlkörperanordnung (1), die einen Kühlkörper (3) und zumindest eine zu kühlende Bauteilkomponente (6) aufweist, mit einer Leiterplatte (4), umfassend die Schritte
a) Bereitstellen eines ersten elektrischen Kontakts (104) und eines zweiten elektrischen Kontakts (105) in oder an der Leiterplatte (4), mit denen der Kühlkörperniederhalter (2) verbindbar ist,
b) Bereitstellen einer Auswerteeinheit (100) mit einem Spannungsausgang (106), der an den ersten elektrischen Kontakt (104) angeschlossen wird, und mit einem Analog- oder Digitaleingang (101), der an den zweiten elektrischen Kontakt (105) angeschlossen wird,
c) Erzeugen eines ersten gepulsten Ausgangsspannungssignals am Spannungsausgang (106), das zumindest einen Flankenwechsel aufweist,
d) Überprüfen, ob die elektrische Spannung am Analog- oder Digitaleingang (101) den mindestens einen Flankenwechsel des ersten gepulsten Ausgangsspannungssignals aufweist,
e) Erzeugen eines zweiten gepulsten Ausgangsspannungssignals am Spannungsausgang (106), das zumindest einen Flankenwechsel aufweist, der vom Flankenwechsel des ersten gepulsten Ausgangsspannungssignals verschieden ist,
f) Überprüfen, ob die elektrische Spannung am Analog- oder Digitaleingang (101) den mindestens einen Flankenwechsel des zweiten gepulsten Ausgangsspannungssignals aufweist.

2. Verfahren nach Anspruch 1, **dadurch gekennzeichnet, dass** der Analog- oder Digitaleingang (101) und der Spannungsausgang (106) der Auswerteeinheit (100) konfigurierbar ausgeführt werden.

3. Verfahren nach einem der Ansprüche 1 oder 2, **dadurch gekennzeichnet, dass** die elektrischen Kontakte (104, 105) in Aufnahmeöffnungen (40, 41) der Leiterplatte (4) bereitgestellt werden, in die der Kühlkörperniederhalter (2) bei der Montage einsteckbar ist.

4. Verfahren nach einem der Ansprüche 1 bis 3, **dadurch gekennzeichnet, dass** die elektrischen Kontakte (104, 105) durch Lötabschnitte bereitgestellt werden, an denen der Kühlkörperniederhalter (2) bei der Montage mit der Leiterplatte (4) verlötet wird.

## Claims

1. Method for testing a mechanical connection of a heatsink retention part (2) of a heat sink assembly (1), having a heatsink (3) and at least one component (6) which needs to be cooled, with a printed circuit board (4), comprising the steps
a) providing, in or on the printed circuit board (4), a first electrical contact (104) and a second electrical contact (105), with which the heatsink retention part (2) can be linked,
b) providing an evaluation unit (100) with a voltage output (106), which is connected to the first electrical contact (104), and with an analogue or digital input (101), which is connected to the second electrical contact (105),
c) generating a first pulsed output voltage signal at the voltage output (106), said signal having at least one flank change,
d) testing, whether the electrical voltage at the analogue or digital input (101) has the at least one flank change of the first pulsed output voltage signal,
e) generating a second pulsed output voltage signal at the voltage output (106), said signal having at least one flank change, which is different from the flank change of the first pulsed output voltage signal,
f) testing, whether the electrical voltage at the analogue or digital input (101) comprises the at least one flank change of the second pulsed output voltage signal.

2. Method according to claim 1, **characterised in that** the analogue or digital input (101) and the voltage output (106) of the evaluation unit (100) are designed to be configurable.

3. Method according to any one of claims 1 or 2, **characterised in that** the electrical contacts (104, 105) are provided in receiving openings (40, 41) of the printed circuit board (4), into which the heatsink retention part (2) can be inserted during assembly.

4. Method according to any one of claims 1 to 3, **characterised in that** the electrical contacts (104, 105) are provided by means of solder sections, where the heatsink retention part (2) is soldered to the printed circuit board (4) during assembly.

## Revendications

1. Procédé de contrôle d'une liaison mécanique d'un dispositif de retenue de corps de refroidissement (2) d'un dispositif de corps de refroidissement (1) qui présente un corps de refroidissement (3) et au moins un composant à refroidir (6) au moyen d'un circuit imprimé (4), comprenant les étapes
a) de mise à disposition d'un premier contact électrique (104) et d'un deuxième contact électrique (105) dans ou sur le circuit imprimé (4), avec lesquels le dispositif de retenue de corps de refroidissement (2) peut être lié,
b) de mise à disposition d'une unité d'analyse (100) comportant une sortie de tension (106) qui est raccordée au premier contact électrique (104), et comportant une entrée analogique ou numérique (101) qui est raccordée au deuxième contact électrique (105),
c) de génération d'un premier signal de tension de sortie pulsé au niveau de la sortie de tension (106) de l'au moins un changement de front,
d) de contrôle pour savoir si la tension électrique au niveau de l'entrée analogique ou numérique (101) présente l'au moins un changement de front du premier signal de tension de sortie pulsé,
e) de génération d'un deuxième signal de tension de sortie pulsé au niveau de la sortie de tension (106) qui présente au moins un changement de front qui est différent du changement de front du premier signal de tension de sortie pulsé,
f) de contrôle pour déterminer si la tension électrique au niveau de l'entrée analogique ou numérique (101) présente l'au moins un changement de front du deuxième signal de tension de sortie pulsé.

2. Procédé selon la revendication 1, **caractérisé en ce que** l'entrée analogique ou numérique (101) et la sortie de tension (106) de l'unité d'analyse (100) sont réalisées de façon à pouvoir être configurées.

3. Procédé selon l'une des revendications 1 ou 2, **caractérisé en ce que** les contacts électriques (104, 105) sont mis à disposition dans des ouvertures de réception (40, 41) du circuit imprimé (4) dans lesquelles le dispositif de retenue de corps de refroidissement (2) peut être inséré lors du montage.

4. Procédé selon l'une des revendications 1 à 3, **caractérisé en ce que** les contacts électriques (104, 105) sont mis à disposition par des parties soudées au niveau desquelles le dispositif de retenue de corps de refroidissement (2) est soudé au circuit imprimé (4) lors du montage.
